# FASCICULE DE BREVET EUROPEEN

(11) **EP 1 117 282 B1**
(45) Date de publication et mention de la délivrance du brevet: **14.06.2006**
(21) Numéro de dépôt: 00403684.4
(22) Date de dépôt: 27.12.2000
(51) Int. Cl.: H05K 1/18, H05K 1/02, H01R 12/32

(54) **Module électronique à composants de puissance et procédé de fabrication**
Elektronisches Modul mit Leistungsbauteilen und Verfahren zur Herstellung
Electronic module with power components and manufacturing method

(30) Priorité: 11.01.2000 FR 0000282
(43) Date de publication de la demande: 18.07.2001
(73) Titulaire: Valeo Systèmes de Contrôle Moteur, 95520 Osny (FR)
(72) Inventeur: Hoche, Jean, 76800 Saint-Etienne-du-Rouvray (FR)
(74) Mandataire: Fruchard, Guy

(56) Documents cités:
- EP-A- 0 680 248
- DE-A- 3 826 999
- DE-A- 4 425 803
- US-A- 4 617 729
- US-A- 4 838 475
- US-A- 5 699 235

## Description

La présente invention a pour objet un module électronique de puissance comportant un substrat métallique, une carte de circuit imprimé portée sur une des faces du substrat et des composants, dont certains au moins de puissance, montés sur la carte qui porte également des moyens d'interconnexion électrique des composants entre eux et avec une alimentation extérieure. L'invention trouve une application importante, bien que non exclusive, dans le domaine de l'électronique automobile dont certains systèmes incorporent des composants actifs, tels que des transistors de commutation, et éventuellement passifs, tels que des condensateurs ou bobines, qui véhiculent des courants élevés en fonctionnement.

L'utilisation de pistes imprimées sur la carte provoque des pertes ohmiques importantes du fait de la section droite relativement faible des pistes et donc de leur résistance électrique élevée. Pour limiter les pertes, on a muni la carte de certains modules actuels d'un circuit formé de barres rapportées sur la carte. Cette constitution, dite à barre bus, présente des inconvénients notables. La conception du tracé demande une étude particulière pour chaque nouveau type de module. La pose demande une planéité élevée, difficile à réaliser. Les barres représentent un volume cuivre important.

Une telle carte est, par exemple, connue de DE-A-4 425 803. L'utilisation de ponts conducteurs pour réaliser une liaison électrique fiable entre des domaines déterminés d'un réseau conducteur porté par un substrat isolant est par ailleurs connu de DE-A- 3826 999.

La présente invention vise notamment à fournir un module électrique de puissance répondant mieux que ceux antérieurement connus aux exigences de la pratique, notamment en ce que les composants supplémentaires qu'il met en oeuvre sont de constitution simples et standardisables de sorte que la conception d'un nouveau type de module n'exige pas une étude complexe.

Dans ce but l'invention propose un module caractérisé en ce que les moyens d'interconnexion comportent des ponts conducteurs de forme leur permettant d'enjamber un composant reliant entre eux des tronçons courts de pistes d'interconnexion véhiculant les courants de puissance.

Les ponts sont avantageusement en forme de cavaliers dont le plus grand nombre ou la totalité ont les mêmes dimensions et dont la longueur et la hauteur sont suffisantes pour enjamber chacun un composant de puissance ou au moins chacun des composants de puissance actifs qui ont habituellement des tailles identiques ou comparables. Ainsi la majeure partie ou tous les ponts peuvent être identiques et de taille à peine supérieure à celle des composants, ce qui permet de les manipuler comme des composants et en particulier de les mettre en place à l'aide de machines automatiques après montage des composants.

Les extrémités des ponts seront généralement soudées sur les tronçons par le même procédé que celui utilisé pour les composants, par exemple par refusion de plages de soudure étain-plomb lorsque les ponts sont en cuivre, éventuellement étamé.

Pour réduire les pertes ohmiques et l'échauffement, on peut donner aux tronçons courts une section droite supérieure à celle de pistes équipotentielles de commande également imprimées sur la carte. La longueur des tronçons sera toujours notablement inférieure à celle des ponts.

Le circuit imprimé peut être simple couche ou multicouches. Une de ses faces, isolante, est collée sur le substrat. Ce dernier sera généralement porté par une paroi refroidie ou contiendra un circuit de fluide de refroidissement., surtout si le module est placé dans une ambiance à température élevée, par exemple sous le capot d'un véhicule automobile en fonctionnement.

L'invention propose également un procédé de fabrication d'un module suivant lequel :
- on fixe une carte de circuit imprimée portant des pistes équipotentielles et des tronçons de piste conductrices de section supérieure à celle des pistes équipotentielles sur une face d'un substrat métallique (10),
- on place des plages de soudure ou brasure en des emplacements des pistes destinés à être reliés aux composants et à des ponts en métal conducteur,
- on place les composants de façon qu'ils soient retenus par la soudure,
- on place les ponts en des emplacements tels que leurs extrémités s'appliquent sur des plages de soudure ou brasure et que les ponts relient les dits tronçons entre eux, et
- on fixe définitivement les composants et les ponts, généralement par refusion.

Les caractéristiques ci-dessus ainsi que d'autres apparaîtront mieux à la lecture de la description qui suit d'un mode particulier de réalisation, donné à titre d'exemple non limitatif. La description se réfère au dessin qui l'accompagne, dans lequel :

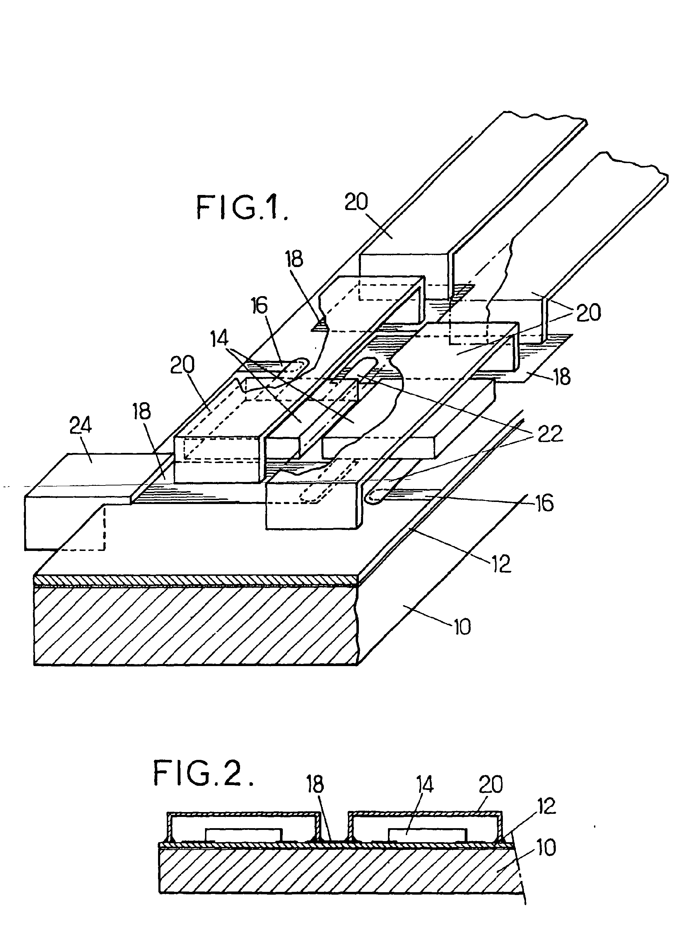

- la figure 1 est un schéma en perspective d'une fraction d'un module conforme à l'invention, l'échelle n'étant pas respectée pour plus de clarté ; et
- la figure 2 est une vue de détail en coupe perpendiculaire au plan du substrat.

Le module représenté comporte un substrat 10 en métal bon conducteur de la chaleur, par exemple en aluminium pur ou allié, portant une carte de circuit imprimé 12. Le substrat a une épaisseur qui peut aller de quelques millimètres à quelques centimètres, suivant qu'il est refroidi sur la face opposée au circuit imprimé (par exemple du fait qu'il est porté par une paroi de refroidissement) ou qu'il contient un circuit de refroidissement.

Sur la carte de circuit imprimé 12 sont soudés des composants de puissance 14, tels que des transistors de commutation dont deux seulement sont représentés, et éventuellement des composants actifs de commande (non représentés) qui ne sont traversés que par des courants de commande faibles. Les composants actifs de commande reçoivent et émettent des signaux qui sont transmis par des pistes de liaison équipotentielle 16 pouvant être des pistes imprimées réalisées de façon classique, par exemple par sérigraphie. De tels signaux de commande sont également transmis entre les composants de puissance 14 d'une part, l'extérieur et les composants de commande d'autre part.

Les moyens d'interconnexion véhiculant des courants de puissance comprennent des tronçons 18 de piste conductrice aussi courts que possible, reliés entre eux par des ponts en métal conducteur 20. Les tronçons 18, en cuivre, ont avantageusement une section plus importante que les pistes équipotentielles. Dans le cas illustré sur la figure, elles sont plus larges. Elles peuvent également être plus épaisses. Les ponts 20 seront généralement en cuivre, étamé ou non, et leur taille sera choisie de façon qu'ils puissent enjamber les composants de puissance et leurs pattes de raccordement 22 en métal. Certaines de ces pattes sont fixées par soudure sur les tronçons 18 et d'autres sur des plages de soudure ou brasure prévues sur les pistes équipotentielles.

Les ponts seront placés de façon que les intervalles entre eux soient aussi réduits que possible. Dans le cas illustré, les ponts sont moins larges que les composants actifs de puissance, mais cette condition n'est pas obligatoire. Pratiquement les ponts seront généralement constitués par un fragment de feuillard de cuivre ayant environ 1mm d 'épaisseur, facile à couder en forme de cavaliers de hauteur légèrement supérieure à celle des composants qu'ils enjambent.

Il sera en général possible d'utiliser un seul type de pont sur un circuit donné, ce qui évite les erreurs. La dimension des ponts est du même ordre de grandeur que celle des composants de puissance, ce qui facilite la mise en place sur la même machine automatique que celle qui est utilisée pour les composants

Le module comporte encore un ou des connecteurs 24 de liaison avec l'extérieur, qui peuvent être de constitution classique et être soudés sur les tronçons.

Un module du genre qui vient d'être décrit est notamment utilisable dans un système de commande électromagnétique de soupapes, qui comprend plusieurs branches ayant la même constitution et donc ayant des composants de puissance identiques, ce qui réduit le nombre de composants différents à assembler.

La fabrication en série de module commence par la réalisation des cartes de circuits imprimés 12 portant des pistes équipotentielles et des tronçons de piste conductrices, de section supérieure à celle des pistes équipotentielles, et leur fixation par collage à l'aide d'un colle conductrice de la chaleur sur une face d'un substrat métallique 10. Les emplacements destinés à être reliés et fixés à des pattes ou contacts des composants et aux extrémités des ponts sont revêtus de soudure ou de pâte à braser, par exemple en étain-plomb ou en cuivre passivé.

Le montage des composants et des ponts n'exige que des opérations maintenant bien maîtrisées et généralement mises en oeuvre sur des machines automatiques. On place d'abord les composants qui sont retenus par adhésion avec la pâte à braser lorsqu'elle est utilisée. On place ensuite les ponts en des emplacements tels que leurs extrémités s'appliquent sur les dépôts de pâte de brasage et qu'ils relient les tronçons entre eux. Enfin on fixe définitivement les composants et les ponts par refusion, par exemple par passage dans un four en atmosphère d'air ou d'azote.

## Revendications

1. Module électronique de puissance comportant un substrat métallique (10), une carte de circuit imprimé (12) portée sur une des faces du substrat et des composants (14), dont certains au moins sont de puissance, montés sur la carte qui porte également des moyens (16) d'interconnexion électrique des composants entre eux et avec une alimentation extérieure, **caractérisé en ce que** les moyens d'interconnexion comportent des ponts en matériau conducteur (20) de forme leur permettant d'enjamber chacun un composant de puissance, reliant entre eux des tronçons courts (18) de pistes d'interconnexion véhiculant les courants de puissance.

2. Module selon la revendication 1, **caractérisé en ce que** les ponts sont en forme de cavaliers dont le plus grand nombre ou la totalité ont les mêmes dimensions et dont la longueur et la hauteur sont suffisantes pour enjamber chacun un composant de puissance.

3. Module selon la revendication 1 ou 2, **caractérisé en ce que** les dits tronçons courts (18) ont une section droite supérieure à celle de pistes équipotentielle de commande également imprimées sur la carte.

4. Module selon la revendication 1, 2 ou 3, **caractérisé en ce que** les dits ponts ont leurs extrémités soudées sur les dits tronçons.

5. Module selon l'une quelconque des revendications 1 à 4, **caractérisé en ce que** le circuit imprimé (12) est simple couche ou multicouches ayant une face isolante collée sur le substrat (10).

6. Module selon l'une quelconque des revendications 1 à 4, **caractérisé en ce que** le dit substrat est porté par une paroi refroidie ou contient une circuit de fluide de refroidissement.

7. Procédé de fabrication d'un module selon l'une quelconque des revendications 3 à 4, **caractérisé en ce qu'**il comporte les étapes suivantes :
- on fixe une carte de circuit imprimée (12) portant des pistes équipotentielles et des tronçons (18) de pister conductrices de section droite supérieure à celle des pistes équipotentielles sur une face d'un substrat métallique (10),
- on place des plages de soudure ou brasure en des emplacements des tronçons destinés à être reliés aux composants et à des ponts en métal conducteur,
- on place les composants (14) de façon qu'ils soient retenus par la soudure,
- on place les ponts (20) en des emplacements tels que les extrémités s'appliquent sur des plages et qu'ils relient les dits tronçons entre eux, et
- on fixe définitivement les composants et les ponts par refusion.

## Claims

1. Power electronics module comprising a metal substrate (10), a printed circuit card (12) carried on one of the faces of the substrate, and components (14), at least some of which are power components, mounted on the card which also carries electrical interconnection means (16) between the components themselves and with external power supply, **characterized in that** the interconnection means include conductive bridges (20) of a shape enabling each of them to extend over a power component and mutually interconnecting short segments (18) of interconnection tracks, that carry power current.

2. Module according to claim 1, **characterized in that** the bridges are staple-shaped, most or all of them having the same sizes and whose length and height are sufficient to enable each of them to straddle a power component.

3. Module according to claim 1 or 2, **characterized in that** the short segments (18) have a cross-section that is greater than that of controlling equipotential tracks also printed on the card.

4. Module according to claim 1, 2 or 3, **characterized in that** said bridges have their ends soldered onto the card.

5. Module according to any one of claims 1-4, **characterized in that** the printed circuit (12) is single layer or is multi-layer with an insulating face, bonded to the substrate (10).

6. Module according to any one of claims 1-4, **characterized in that** said substrate is carried by a cooled wall or contains a circuit for a cooling fluid.

7. Method of manufacturing a module according to any one of claims 3-4, **characterized in that** it comprises the following steps :
- securing a printed circuit card (12) carrying equipotential tracks and segments (18) of conducting track of cross-section greater than that of the equipotential tracks on one face of a metal substrate (10) ;
- placing solder or brazing areas at locations of the tracks which are to be connected to components and to bridges of conductive metal ;
- locating the components (14) in such a manner as to enable them to be secured by the solder ;
- placing the bridges (20) at locations such that their ends bear against solder or brazing areas and the bridges interconnect said segments to one another ; and
- definitively fixing the components and the bridges by reflow soldering.

## Patentansprüche

1. Elektronisches Leistungsmodul, umfassend
einen metallischen Träger (10),
eine gedruckte Leiterplatte (12), die auf einer der Flächen des Trägers getragen wird, und
Bauteile (14), von denen mindestens einige Leistungsbauteile sind, die auf der Platte angebracht sind, die gleichermaßen Mittel (16) zum elektrischen Verbinden von Bauteilen miteinander und mit einer externen Versorgung trägt, **dadurch gekennzeichnet, dass** die Verbindungsmittel Brücken (20) aus leitendem Material umfassen, die derart geformt sind, dass jede ein Leistungsbauteil überspannen kann, wobei sie kurze Abschnitte (18) von Leiterbahnen, die die Leistungsströme transportieren, untereinander verbinden.

2. Modul nach Anspruch 1, **dadurch gekennzeichnet, dass** die Brücken die Form von Klammern haben, von denen ein großer Teil oder alle die gleichen Maße haben, und die eine ausreichend Länge und Höhe haben, sodass jede von ihnen ein Leistungsbauteil überspannt.

3. Modul nach Anspruch 1 oder 2, **dadurch gekennzeichnet, dass** die kurzen Abschnitte (18) einen größeren Querschnitt haben als die äquipotentialen Steuerbahnen, die ebenfalls auf der Platte gedruckt sind.

4. Modul nach Anspruch 1, 2 oder 3, **dadurch gekennzeichnet, dass** die Enden der Brücken auf den Abschnitten verlötet sind.

5. Modul nach einem der Ansprüche 1 bis 4, **dadurch gekennzeichnet, dass** die Leiterplatte (12) einlagig oder mehrlagig ist und eine Isolierfläche hat, die auf den Träger (10) geklebt ist.

6. Modul nach einem der Ansprüche 1 bis 4, **dadurch gekennzeichnet, dass** der Träger von einer gekühlten Wand getragen wird oder einen Kühlmittelkreis enthält.

7. Verfahren zur Herstellung eines Moduls nach einem der Ansprüche 3 bis 4, **dadurch gekennzeichnet, dass** es die folgenden Schritte umfasst:
- Befestigen einer gedruckten Leiterplatte (12), die äquipotentiale Bahnen und Abschnitte (18) von Leiterbahnen mit einem Querschnitt, der größer ist als der der äquipotentialen Bahnen, auf einer Fläche eines metallischen Trägers (10),
- Anbringen von Schweiß- oder Lötflächen an Stellen der Abschnitte, die dazu bestimmt sind, mit Bauteilen und mit Brücken aus leitfähigem Material verbunden zu werden,
- Anbringen der Bauteile (14) derart, dass sie durch die Lötverbindung festgehalten werden,
- Anbringen der Brücken (20) in Stellen derart, dass die Enden auf Schweiß- oder Lötflächen aufliegen und dass sie die Abschnitte untereinander verbinden, und
- endgültiges Befestigen der Bauteile und der Brücken durch Aufschweißen.
